(19) **Europäisches Patentamt / European Patent Office / Office européen des brevets**

(11) **EP 1 491 908 B1**

(12) **EUROPÄISCHE PATENTSCHRIFT**

(45) Veröffentlichungstag und Bekanntmachung des Hinweises auf die Patenterteilung:
**13.08.2008   Patentblatt 2008/33**

(51) Int Cl.:
***G01R 33/28*** *(2006.01)*

(21) Anmeldenummer: **04014220.0**

(22) Anmeldetag: **17.06.2004**

(54) **Verfahren zur kernspintomographischen Aufnahme von bewegten Objekten**

MR method of imaging objects in motion

Méthode d'imagerie par résonance magnétique d'objets mouvants

(84) Benannte Vertragsstaaten:
**AT CH DE GB LI**

(30) Priorität: **25.06.2003   DE 10328423**

(43) Veröffentlichungstag der Anmeldung:
**29.12.2004   Patentblatt 2004/53**

(60) Teilanmeldung:
**05015592.8 / 1 598 676**

(73) Patentinhaber: **Universitätsklinikum Freiburg**
**78106 Freiburg (DE)**

(72) Erfinder:
 • **Hennig, Jürgen**
  **79100 Freiburg (DE)**
 • **Speck, Oliver**
  **79110 Freiburg (DE)**

(74) Vertreter: **Kohler Schmid Möbus**
**Patentanwälte**
**Ruppmannstrasse 27**
**70565 Stuttgart (DE)**

(56) Entgegenhaltungen:
  **EP-A- 0 642 031          EP-A- 0 654 675**
  **US-A1- 2002 140 423**

 • **Y. ZHU, CH.L. DUMOULIN: "Extended field-of-view imaging with table translation and frequency sweeping." MAGNETIC RESONANCE IN MEDICINE, Bd. 49, Nr. 6, Juni 2003 (2003-06), Seiten 1106-1112, XP001163044 ISSN: 0740-3194**

## Beschreibung

Die Erfindung betrifft ein Verfahren der Kernspinresonanz(=NMR)-Tomographie zur Untersuchung eines Zielobjekts, bei dem Hochfrequenz(=HF)-Impulse in ein Zielvolumen einstrahlt und/oder HF-Impulse aus dem Zielvolumen detektiert werden, wobei das Zielvolumen durch die Frequenz der HF-Impulse und/oder durch Magnetfeldgradienten bestimmt ist, und wobei das Zielobjekt während der NMR-Datenaufnahme relativ zum NMR-Tomographen bewegt wird.

NMR-Tomographieverfahren mit bewegten Zielobjekten sind bekannt aus Kruger et al., Magnet. Reson. Med. 47 (2002), 224, oder auch Scheffler, Proc. 9th Meeting ISMRM, Glasgow (2001), 1774.

NMR-Tomographie wird vor allem in der medizinischen Diagnostik angewandt, um Informationen über das Volumen (d.h. das Innere) eines Zielobjekts, insbesondere über erkrankte oder möglicherweise erkrankte Regionen eines menschlichen Körpers zu erhalten. Dabei wird die Wechselwirkung von Atomkernen mit elektromagnetischen Impulsen ausgenutzt.

Typischerweise erfolgen NMR-Bildaufnahmen in einzelnen, ebenen Schichten. Zur Untersuchung von größeren Zielobjekten können Einzelaufnahmen von mehreren Schichten des Zielobjekts angefertigt werden. Ist die Aufnahme einer Schicht beendet, wird das Zielobjekt ein wenig senkrecht zur Schichtebene relativ zum NMR-Tomographen verschoben, und anschließend wird eine weitere Schicht aufgenommen. In diesen einfachen Fällen ist das Zielobjekt während der eigentlichen NMR-Datenaufnahme unbeweglich.

Aufnahmeverfahren von während der NMR-Datenaufnahme bewegten Objekten (vor allem zur Anwendung für sogenanntes Ganzkörper-Imaging) sind aus der Literatur bekannt (s. z.B. Kruger et al, Magnet. Reson. Med.47 (2002), 224). Hierbei wurden bisher unterschiedliche Prinzipien verwendet.

Zum einen wurden Verfahren entwickelt, bei welchen die Bewegung innerhalb der Aufnahmeebene (d.h. der Schicht) stattfindet. Bei ortsfesten Magnetfeldgradienten führen solche Bewegungen primär zu einer Verschiebung der Aufnahmedaten bezogen auf das aufgenommene Zielobjekt. Bei Verwendung von Aufnahmeverfahren, die auf der wiederholten Aufnahme jeweils unterschiedlich ortskodierter Signale beruhen, ist diese Verschiebung entsprechend der kontinuierlichen Bewegung des Objektes von einem Aufnahmeschritt zum andern unterschiedlich. Diese Verschiebung lässt sich jedoch bei bekannter Verschiebungsgeschwindigkeit durch entsprechende Datennachverarbeitung kompensieren. Ein solches Verfahren ist beispielsweise aus "Extended Field-of-View Imaging With Table Translation and Frequency Sweeping" von Zhou und Dumoulin (Mag. Res. In Medicine 49) bekannt.

Verfahren zur Aufnahme von Bildern bei Bewegung senkrecht zur Aufnahmeebene sind ebenfalls bekannt (s. z.B. Scheffler, Proc. 9th Meeting ISMRM, Glasgow, (2001), Seite 1774). Bei den bisher bekannten Verfahren wird hierbei die Verschiebungsgeschwindigkeit so gewählt, dass die verschiebungsbedingte Inkonsistenz der Daten klein bleibt und die Aufnahmequalität nicht wesentlich beeinträchtigt. Im Allgemeinen werden diese Verfahren so durchgeführt, dass der Bewegungsvorschub über eine Bildaufnahme klein ist gegenüber der Dicke des ausgewählten (d.h. zu untersuchenden) Volumens. Für solche Aufnahmeverfahren werden zudem schnelle Aufnahmetechniken wie etwa trueFISP- oder Gradientenechosequenzen gewählt, welche gegenüber bewegungsbedingten Bildartefakten weitgehend stabil sind. Nachteilig diesen Verfahren bleibt, dass der geringe Bewegungsvorschub die Gesamtdauer der NMR-Untersuchung in die Länge zieht.

Aus EP 0 654 675 A und EP 0 642 031 A sind Verfahren der NMR-Tomographie bekannt, bei denen die Frequenz der HF-Impulse und/oder die Magnetfeldgradienten während der NMR-Datenaufnahme so verändert werden, dass das von den HF-Impulsen erfasste Zielvolumen während der NMR-Datenaufnahme mit der gleichen Geschwindigkeit und Bewegungsrichtung wie das Zielobjekt relativ zum NMR-Tomographen bewegt wird. Dabei wird während der NMR-Datenaufnahme ein schichtförmiges Zielvolumen untersucht. Dadurch werden bekannte Schichtselektionsgradienten zur Auswahl des Zielvolumens anwendbar. Bei dem Verfahren kann eine Mehrschichttechnik zur Untersuchung von ns Schichten angewendet werden. Durch eine Mehrschichttechnik kann die Messzeit bei größeren Zielobjekten erheblich verkürzt werden.

Es können mehrere NMR-Datenaufnahmen zyklisch wiederholt werden. Damit können Zielobjekte von in Bewegungsrichtung beliebiger Länge kontinuierlich untersucht werden. Bei jeder NMR-Datenaufnahme kann ein anderer Bereich des Zielobjekts untersucht werden, der im Messzeitraum jeweils im Inneren des NMR-Tomographen angeordnet ist.

Aufgabe der vorliegenden Erfindung ist es demgegenüber, ein Verfahren zur Untersuchung eines bezüglich des NMR-Tomographen während der NMR-Datenaufnahme bewegten Zielobjekts vorzustellen, das schnell und einfach durchführbar ist, und mit dem eine verkürzte Messzeit realisiert werden kann.

Diese Aufgabe wird durch ein Verfahren mit den Merkmalen des Patentanspruchs 1 gelöst.

In Inneren des NMR-Tomographen wird das Zielobjekt bewegt. Dabei ist ein kleiner Teil dieses Inneren des NMR-Tomographen durch die Magnetfeldgradienten, insbesondere Schichtselektionsgradienten, sowie die Frequenz der HF-Impulse zur Datenaufnahme als Zielvolumen ausgewählt. Erfindungsgemäß werden nun die Frequenz der HF-Impulse und/oder die Stärke der Magnetfeldgradienten während der NMR-Datenaufnahme so verändert, dass die Position dieses Zielvolumens mit dem bewegten Zielobjekt mitgeführt wird. Dadurch werden die NMR-Daten stets aus dem selben lokalen Bereich des Zielobjekts gewonnen.

Dadurch, dass bei einer NMR-Datenaufnahme mit m zur vollständigen Schichtrekonstruktion notwendigen Einzelschritten nach k=np*m/ns Einzelschritten die Position des Zielvolumens um einen Abstand ds verändert wird, der dem räumlichen Abstand der Position benachbarter Schichten entspricht, so dass nach Aufnahme von N*m Einzelschritten zu insgesamt N*ns-(ns/np-1) Schichten vollständige Daten zur Bildrekonstruktion vorliegen, wobei $np \geq 1$ (und bevorzugt np=1), $N \geq 1$, kann gegenüber der oben beschriebenen Aufnahme im Elnzelschichtverfahren eine Zeitersparnis bei der Untersuchung großer Zielobjekte um einen Faktor ns erzielt werden.

Die Mitführung des Zielvolumens mit dem Zielobjekt wird außerdem vereinfacht, wenn die Bewegung des Zielobjekts senkrecht zur Schichtnormalen (d.h. der Aufnahmeebene) erfolgt. Eine Kippung der Ebene ist jedoch ebenfalls möglich, solange die Bewegung zumindest eine von Null verschiedene Komponente senkrecht zur Aufnahmeebene aufweist.

Eine besonders bevorzugte Ausgestaltung dieser Verfahrensvariante sieht vor, dass die Bewegung des Zielobjekts parallel zur Oberflächennormalen des schichtförmigen Zielvolumens erfolgt. In einer Dimension lang ausgedehnte Zielobjekte können durch das Innere des NMR-Tomographen hindurchgeführt werden (oder auch der NMR-Tomograph über das Zielobjekt hinweg). Eine Untersuchung des Zielobjekts (etwa eines Menschen) kann dann grundsätzlich über dessen gesamte Länge erfolgen, typischerweise bei mehreren NMR-Datenaufnahmen von verschiedenen Schichten und andauernder Relativbewegung des Zielobjekts zum NMR-Tomographen während und zwischen allen NMR-Datenaufnahmen.

Eine bevorzugte Variante des erfindungsgemäßen Verfahrens sieht vor, dass während der NMR-Datenaufnahme die Magnetfeldgradienten konstant gehalten werden und nur die Frequenz der HF-Impulse verändert wird. Eine ständige Veränderung des Magnetfeldgradienten ist nur schwer mit großer Exaktheit durchzuführen, insbesondere da Abschirmungen dem veränderlichen Gradienten angepasst werden müssten. Demgegenüber ist eine exakte Einstellung der Frequenz der HF-Impulse relativ einfach, und eine hohe Aufnahmequalität der NMR-Datenaufnahme kann erreicht werden.

Eine besonders bevorzugte Ausgestaltung der Verfahrensvariante ist dadurch gekennzeichnet, dass für die Larmorfrequenz ω der HF-Impulse gilt:

$$\omega(t) = \gamma^*B_0 + \gamma^*GS^*v^*t \quad ,$$

mit γ: gyromagnetisches Verhältnis, $B_0$: statisches Magnetfeld, GS: Magnetfeldgradient, v: Geschwindigkeit des Zielobjekts, und t: Zeit. Das Zielobjekt bewegt sich dabei mit konstanter Relativgeschwindigkeit zum NMR-Tomographen senkrecht zur Aufnahmeebene. bei dieser Frequenzeinstellung ist die Mitführung von Zielvolumen mit dem Zielobjekt auf einfache Weise gewährleistet. Eine zeitlich lineare Veränderung der Larmorfrequenz der Hochfrequenz(=HF)-Impulse ist einfach einzustellen.

Bei einer vorteilhaften Verfahrensvariante wird das Zielobjekt relativ zum NMR-Tomographen gleichförmig bewegt. Dadurch wird die Anpassung der Frequenz der HF-Impulse und/oder der Magnetfeldgradienten besonders einfach. Auch ist eine gleichförmige Bewegung des Zielobjekts einfach einzustellen und für das möglicherweise menschliche Zielobjekt auch schonend. Unter einer gleichförmigen Bewegung wird eine unbeschleunigte, geradlinige Bewegung verstanden.

Ebenfalls bevorzugt ist eine Verfahrensvariante, die dadurch gekennzeichnet ist, dass die Magnetfeldgradienten in Bewegungsrichtung des Zielobjekts bewegungskompensiert bezüglich der Geschwindigkeit des Zielobjekts sind, insbesondere dass die Magnetfeldgradienten bipolar bewegungskompensiert sind. Dadurch lässt sich eine geschwindigkeitsabhängige Dephasierung der HF-Impulse vermeiden.

Eine weitere, bevorzugte Verfahrensvariante sieht vor, dass eine Multiecho-Sequenz nach dem Prinzip des RARE-Verfahrens angewendet wird, wobei zusätzlich die Pulsphase entsprechend den CPMG-Bedingungen der Bewegung des Zielobjektes angepasst wird. Das RARE-Verfahren verwendet mehrere Anregungsimpulse, so dass dieses Verfahren bei bewegten Zielobjekten ohne die erfindungsgemäße Mitführung des Zielvolumens nicht anwendbar wäre.

Ebenso in den Rahmen der vorliegenden Erfindung fällt ein Verfahren der NMR-Tomographie zur Untersuchung eines Zielobjekts, das dadurch gekennzeichnet ist, dass mehrere NMR-Datenaufnahmen durch obige erfindungsgemäße Verfahren nacheinander durchgeführt werden, und wobei nach jeder NMR-Datenaufnahme die Position des Zielvolumens relativ zum NMR-Tomographen auf eine Ausgangsposition zurückgesetzt wird. Der NMR-Tomograph besitzt einen zulässigen Verfahrbereich für den zu vermessenden Bereich des Zielobjekts, in dem die NMR-Datenaufnahme erfolgt. nach Abschluss der NMR-Datenaufnahme für diesen Bereich (typischerweise diese Schicht) springt das Zielvolumen zurück, um einen neuen Bereich des Zielobjekts zu untersuchen. So kann das Zielobjekt effektiv bereichsweise abgetastet werden.

Besonders bevorzugt ist eine Variante dieser beiden letzten Verfahren, die vorsieht, dass während einer NMR-Datenaufnahme ein schichtförmiges Zielvolumen untersucht wird, und dass das Zielobjekt sich während einer NMR-Datenaufnahme genau um eine Schichtdicke weiter bewegt. In diesem Fall grenzen die nacheinander untersuchten Bereiche des Zielobjekts unmittelbar aneinander an, so dass während des gesamten NMR-Verfahrens das Zielobjekt vollständig untersucht (d.h. abgebildet) werden kann.

Besonders vorteilhaft ist eine Variante des erfindungsgemäßen Verfahrens, bei der während einer NMR-Datenaufnahme eine verschachtelte Anwendung von zwei oder mehreren Messsequenzen erfolgt, wobei die Messsequenzen im allgemeinen zu Signalen mit unterschiedlichem Kontrast führen, und wobei jede Messsequenz jeweils auf ein unterschiedliches Teilvolumen des Zielobjekts wirkt. So lassen sich bei einmaligem Durchfahren des Zielobjekts durch den NMR-Tomographen zwei oder mehr Bildkontraste akquirieren.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung dargestellt und wird anhand von Ausführungsbeispielen näher erläutert. Es zeigt:

Figur 1: eine schematische Illustration des Signalverlustes durch Auswandern des angeregten Bereichs eines bewegten Zielobjekten im Stand der Technik;

Figur 2: eine schematische Illustration des Signalverlustes durch Auswandern einer Struktur S eines bewegten Zielobjekts im Stand der Technik;

Figur 3: eine schematische Darstellung der Phasenlage eines Spins in einem bewegten Zielobjekt im Stand der Technik;

Figur 4: eine schematische Darstellung des erfindungsgemäßen Verfahrens mit den Einzelschritten A1 bis Am.

Figur 5: eine schematische Darstellung des erfindungsgemäßen Prinzips einer kontinuierlichen Aufnahme eines gleichförmig bewegten Zielobjekts;

Figur 6: eine schematische Darstellung des erfindungsgemäßen Prinzips einer kontinuierlichen Aufnahme bei Anwendung eines Mehrschichtverfahrens mit ns Einzelschritten;

Figur 7: eine schematische Darstellung einer erfindungsgemäßen NMR-Datenaufnahme mit 2 Impulssequenzen für unterschiedliche Bildkontraste.

Die Erfindung betrifft NMR-Aufnahmetechniken, bei welchen die Verschiebung nicht in der Ebene des aufgenommenen Bildes (insbesondere Schicht) stattfindet, sondern bei welchen während der Aufnahme eine Verschiebung des Zielobjektes senkrecht zur Bildebene stattfindet.

Für die Auswirkungen einer solchen Verschiebung ist zu beachten, dass die Datenaufnahme eines Magnetresonanz (=MR)-Bildes sequentiell erfolgt und bei vielen Aufnahmeverfahren durch wiederholte Aufnahme von Einzelschritten erfolgt, welche sich im Falle des allgemein verwendeten Verfahrens der Fourier-Transformation durch Änderung der jeweiligen Phasenkodierung der Einzelschritte unterscheidet.

Die Bewegung des Zielobjektes während der Aufnahme kann zum einen die Signalintensität jedes Einzelschrittes betreffen, zum anderen die Konsistenz der zur Bildrekonstruktion verwendeten Gesamtzahl der Einzelschritte.

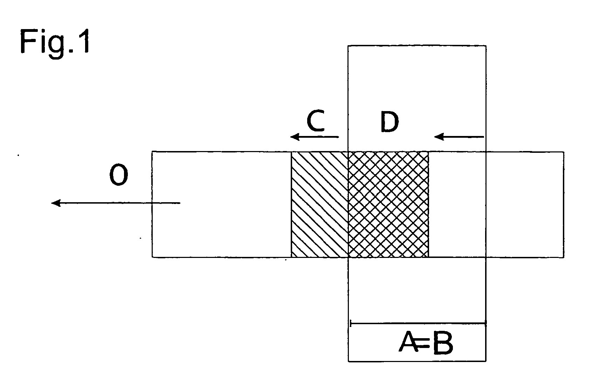

In ersterem Fall tritt ein Signalverlust immer dann ein, wenn zur Signalerzeugung mehr als ein einzelner, schichtselektiver Hochfrequenzimpuls verwendet wird. Dies ist z.B. bei Spinecho-Verfahren der Fall, bei welchen zur Signalerzeugung ein Anregungspuls gefolgt von mindestens einem, im Falle des RARE (oder auch TSE, FSE genannten) Verfahrens auch mehrere Anregungsimpulse angewendet werden. Bewegt sich das Objekt während der Anwendung einer solchen Sequenz, so tritt schon bei der Aufnahme jeden Einzelschritts ein Signalverlust dadurch auf, dass sich ein Teil des untersuchten Volumens aus dem durch die Messsequenz erfassten Volumen bewegt und die darin enthaltenen Spins sich damit der Messung entziehen (Fig.1).

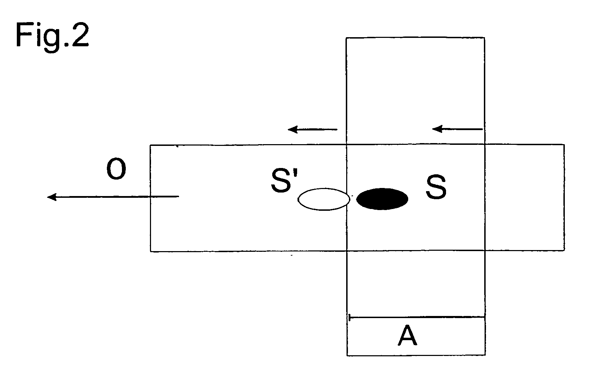

Ein weiterer Effekt tritt dann ein, wenn eine darzustellende Struktur zwar während der Aufnahme eines Einzelschrittes weitgehend in der untersuchten Schicht verbleibt, sich jedoch während der Aufnahme der Gesamtzahl der Einzelschritte (d.h. der Gesamtdauer einer NMR-Datenaufnahme einer Schicht) aus dem Untersuchungsvolumen herausbewegt. Für Spins aus einer solchen Struktur S innerhalb des bewegten Zielobjektes werden dann die zur Bildrekonstruktion benötigten Daten nur unvollständig aufgenommen, was zu Bildartefakten, insbesondere Unschärfe führt (Fig.2).

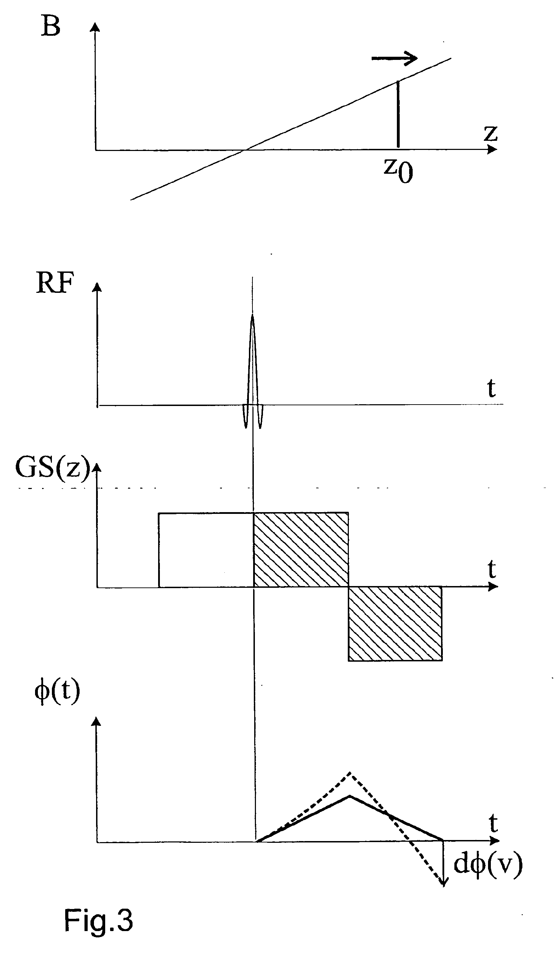

Zusätzlich zu diesen Partialvolumeneffekten treten weitere Signalverluste bzw. Bildartefakte dadurch auf, dass durch die Bewegung der Spins die Rephasierungsbedingungen für die während der Aufnahme zur Ortskodierung verwendeten Gradienten nicht mehr erfüllt sind. (Fig.3): Während der Schichtselektion durch einen Hochfrequenzimpuls in Anwesenheit eines Schichtselektionsgradienten erfahren Spins eine Dephasierung auf Grund ihrer Larmorpräzession im jeweils lokalen Magnetfeld, welches sich aus Überlagerung des ortsunabhängigen Grundfeldes B0 mit einem durch den Schichtselektionsgradienten gegebenen ortsabhängigen Anteil ergibt. Spins an unterschiedlichen Positionen in Richtung des verwendeten Gradienten erfahren so eine unterschiedliche Dephasierung, welche durch entsprechende kompensatorische Gradientenschritte vor der Signalauslesung rückgängig gemacht werden muss. Für ein nicht bewegtes Objekt kann diese Dephasierung im einfachsten Fall durch einen nachfolgenden Gradienten negativer Amplitude und gleicher Fläche kompensiert werden. Bewegt sich das Objekt nun während der Aufnahme, so führt dies durch die Bewegung zu einer kontinuierlichen Änderung des Magnetfeldes am Ort des Spins. Die Phasenentwicklung solcher bewegter Spins entspricht dann einer quadratischen Form entsprechend

$$\Delta\Phi = \gamma \int GS\, z(t)\, dt = 1/2\, v_z\, t^2\, \gamma\, GS,$$

mit $\Delta\Phi$: Phasenverschiebung; $\gamma$: gyromagnetisches Verhältnis; GS: Schichtselektionsgradient, z: Relativposition des untersuchten Bereichs des Zielobjekts im NMR-Tomographen; t: Zeit; $v_z$: Relativgeschwindigkeit des Zielobjekts. Diese Phasenverschiebung ist vor allem bei sogenannten Multiecho-Verfahren (als fast spin echo (FSE), turbo spin echo (TSE) oder RARE (Rapid acquisition with relaxation enhancement) bekannt) relevant, da sie zu einer Störung der Kohärenz der Refokussierung über mehrere Echos und damit zu einem drastischen Signalverlust führen.

Aus diesen Überlegungen ergeben sich folgende erfindungsgemäße Maßnahmen zur Wiederherstellung der Konsistenz der Datenaufnahme.

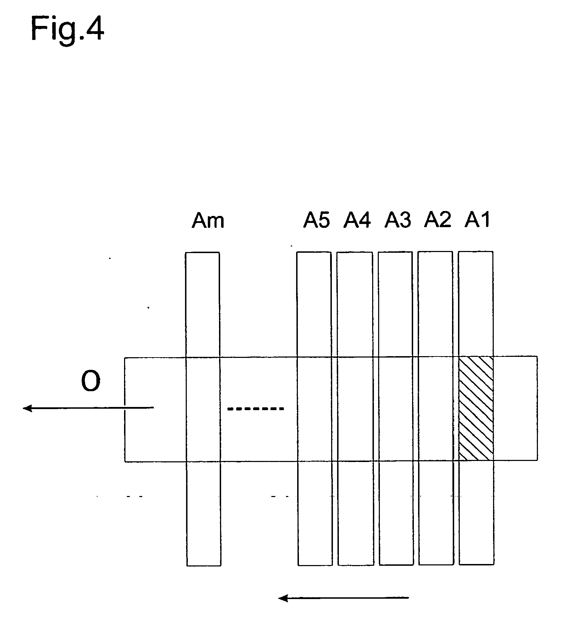

Zum einen wird die durch den Schichtselektionsgradienten und den frequenzselektiven Anregungsimpuls definierte Schicht während der Aufnahme mit dem bewegten Zielobjekt mitgeführt, so dass die Pulssequenz jeweils auf identische Volumenbereiche des bewegten Zielobjektes wirkt (Fig.4). Dies wird entsprechend dem Prinzip der Schichtselektion vorteilhaft dadurch bewirkt, dass der Schichtselektionsgradient für die einzelnen Anregungsschritte während der Anwendung der frequenzselektiven Hochfrequenzimpulse jeweils - wie bei der Aufnahme eines stationären Objektes - konstant bleibt, die Selektionsfrequenz jedoch entsprechend der Bewegung des Objektes verändert wird.

Entsprechend der Larmorbeziehung gilt dabei:

$$\omega = \gamma B = \gamma B_0 + \gamma\, GS\, z = \gamma B_0 + \gamma\, GS\, v_z\, t = \omega_0 + \Delta\omega \qquad [1]$$

Hierbei ist $\omega$ die Larmorfrequenz, $\gamma$ das gyromagnetische Verhältnis und B die magnetische Flussdichte am Ort der Spins. Diese setzt sich zusammen aus der Flussdichte $B_0$ des verwendeten Magneten sowie dem Beitrag des Gradienten GS am Ort z. Der jeweilige Ort der bewegten Spins zum Zeitpunkt t ergibt sich dabei aus der Geschwindigkeit $v_z$.

Für einen Schichtselektionsgradienten GS einer Stärke von 20 mT/m, einer Verschiebungsgeschwindigkeit von 1 cm/s ergibt sich dabei eine Frequenzverschiebung um ~ 850 Hz über 100 ms.

Für die Verwendung in einem Multiecho-Experiment muss die Frequenzverschiebung hierbei innerhalb jedes Echozuges erfolgen, d.h. aufeinanderfolgende Refokussierungsimpulse besitzen unterschiedliche Frequenzen, wobei auch die Phase der Pulse entsprechend den CPMG-Bedingungen jeweils so gewählt werden muss, dass die Phasenkohärenz der Spins erhalten bleibt.

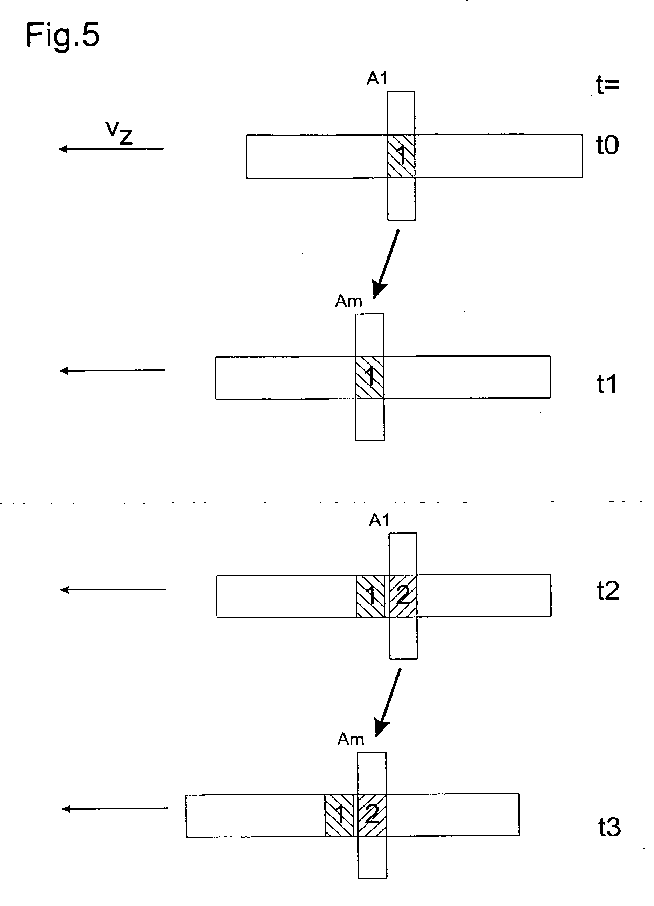

Im einfachsten Falle der Verwendung einer Pulssequenz, welche inhärent Signale aus einer einzelnen Schicht anregt und bei welcher zur Aufnahme eines zur Bildrekonstruktion vollständigen Datensatzes m Aufnahmeschritte erforderlich sind, wird die Aufnahme so durchgeführt, dass das jeweils selektierte Anregungsvolumen (Zielvolumen) über diese m Schritte entsprechend der Verschiebungsgeschwindigkeit zwischen der Position A1 und Am in Fig.5 mitbewegt wird. Anschließend kann dann die Aufnahme wiederholt werden, wobei bei Wahl derselben Schichtpositionen A1 bis Am im bewegten Zielobjekt auf Grund dessen Bewegung eine entsprechend parallel verschobene, neue Schicht des Zielobjekts aufgenommen wird. Wird hierbei die Bewegungsgeschwindigkeit so gewählt, dass Am gegenüber A1 um gerade einen Schichtabstand ds verschoben wird, so wird durch die zyklische Wiederholung eine lückenlose Aufnahme des Objektes erreicht.

Bei Verwendung einer Mehrschichtaufnahmetechnik mit ns Einzelschichten lässt sich das Messprinzip auch folgendermaßen modifizieren:

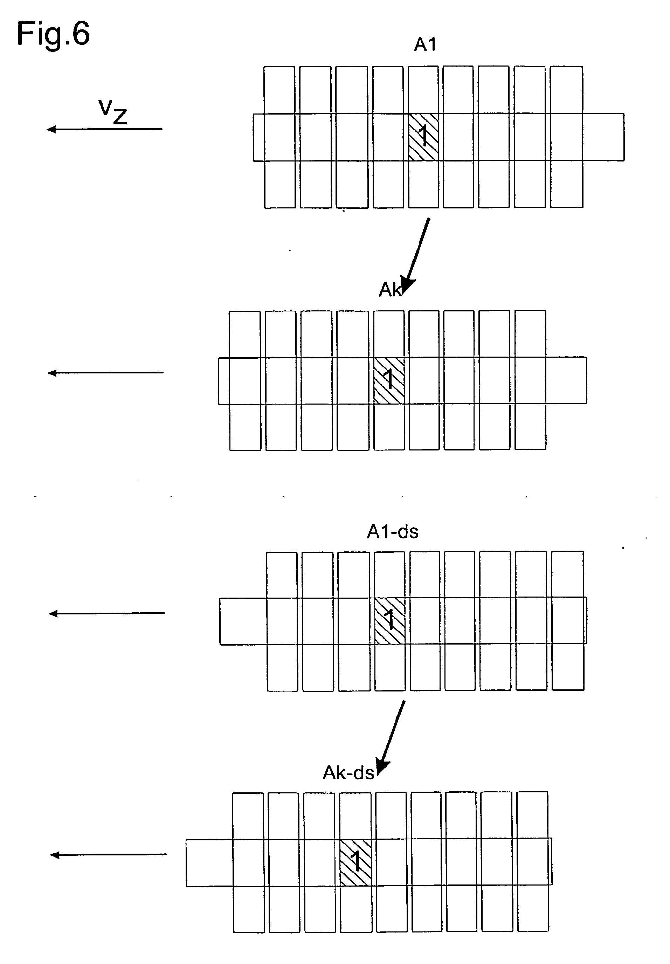

Die Schichtposition wird über k= np*m/ns Aufnahmeschritte mitgeführt, wobei np>=1 <=ns ist. Nach Aufnahme der Aufnahmeschritte A1..Ak wird die Schichtposition im ruhenden Koordinatensystem des Untersuchungsmagneten um einen Schichtabstand ds weitergeschaltet (Fig.6). Nach m Aufnahmeschritten liegen dann aus NS=ns-(ns/np-1) Schichten vollständige Daten zur Bildrekonstruktion vor, dieser Zyklus wird anschließend N-fach wiederholt, so dass insgesamt aus (N-1)ns+NS = N ns-(ns/np-1) Schichten vollständige Daten zur Bildrekonstruktion vorliegen. Im Allgemeinen wird N groß gewählt, so dass das gesamte untersuchte Volumen (z.B. der gesamte Körper) groß ist gegenüber dem von den ns Schichten abgedeckten jeweiligen Aufnahmevolumen. Die Tatsache, dass aus (ns-NS) Schichten keine vollständigen Daten zur Bildrekonstruktion vorliegen, kann dann vernachlässigt werden.

Schließlich soll noch darauf hingewiesen werden, dass das Verfahren auch unter Einsatz von dreidimensionaler Ortskodierung eingesetzt werden kann. Hierbei entsprechen die Aufnahmeschritte A1...Am den Einzelschritten zur Aufnahme eines drei-dimensionalen Datensatzes, das Aufnahmevolumen wird jeweils mit dem bewegten Objekt mitgeführt.

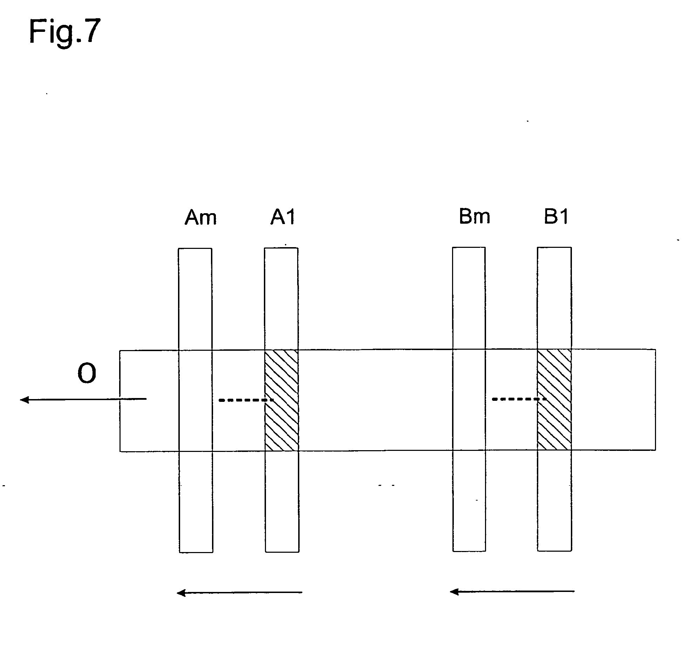

Eine weitere und sehr wesentliche und neue Art der Anwendung des Messprinzips ergibt sich aus der Erkenntnis, dass sich das Verfahren dergestalt modifizieren lässt, dass eine Aufnahme von Bildern mit unterschiedlichem Kontrast simultan durch Anwendung der beschriebenen Prinzipien an räumlich getrennten Positionen durchführen lässt. Dies ist in Fig.7 dargestellt. Hierbei erfolgen Aufnahmen von Signalen jeweils in den durch A1..Am und B1..Bm markierten Positionen im NMR-Tomographen. Innerhalb jedes dieser zwei (oder auch mehrerer) Untersuchungsvolumina (Zielvolumina) wird hierbei eine Datenaufnahme mit völlig unabhängigen Messsequenzen durchgeführt und daher Bilder mit völlig unabhängigem Kontrast erzeugt. Nach einmaligem Durchfahren des Körpers lassen sich so bei kontinuierlicher Erfassung des gesamten Zielobjektes (nahezu) gleichzeitig erzeugte Datensätze mit unterschiedlichem Kontrast erzeugen. Um das Kontrastverhalten der Signale unabhängig voneinander zu gestalten, muss die Bewegung des Objektes dabei hinreichend langsam sein, dass sich Spins, welche in das Untersuchungsvolumen B eintreten bezüglich der kontrastrelevanten Parameter von der vorherigen Signalanregung durch die auf A wirkende Sequenz hinreichend erholt haben. Die auf die Teil-Zielvolumina wirkenden Sequenzen sind dabei völlig unabhängig konfigurierbar. Um ähnliche oder gleiche Volumenabdeckung zu erreichen ist es in den meisten Fällen jedoch vorteilhaft (wenn auch nicht zwingend erforderlich), dass die Sequenzen ähnliche oder gleiche Aufnahmezeiten für einen Aufnahmezyklus erreichen. Die Aufnahme kann dabei entweder durch Verschachtelung der Einzelschritte erfolgen (A1 - B1 - A2 - B2 ....) oder auch - bei hinreichend schnellen Aufnahmetechniken - in einer Segment-weisen Verschachtelung bis hin zur Verschachtelung der gesamten Aufnahme eines Datensatzes (A1- A2 -... - Am- B1 - B2 - ... -Bm).

In der Praxis typische und häufig verwendeten Aufnahmeverfahren für eine solche verschachtelte Aufnahme mit unterschiedlichem Kontrast sind Kombinationen häufig verwendeter Sequenzen wie T1-gewichtete Aufnahme, T2-gewichtete Aufnahme, STIR, FLAIR, diffusionsgewichtete Aufnahmen u.v.m.

Die durch die Ortsänderung des Zielobjektes und damit der untersuchten Spins während der Messung auftretende geschwindigkeitsabhängige Dephasierung der Signale lässt sich durch Verwendung von Gradienten vermeiden, die bezüglich einer konstanten Geschwindigkeit kompensiert sind. Dies ist analog dem bekannten Prinzip flusskompensierter Messverfahren (s. z.B. Duerk et al, Magn. Reson. Imaging 8 (1990), 535). Notwendige und hinreichende Bedingung hierfür ist es, dass neben dem Integral unter dem Gradienten zwischen Anregung und Auslesung auch das Integral des Quadrats des Gradienten auf null gesetzt wird. Dies wird im einfachsten Fall durch sogenannte bipolare bewegungskompensierte Gradienten erreicht.

Erläuterung der Figuren:

Fig.1    Darstellung des Signalverlustes bei ortsfester Aufnahme eines Teilvolumens A, bei welcher das Objekt O sich in Pfeilrichtung bewegt. Ist das vom Anregungspuls erfasste Teilvolumen A identisch mit dem durch den Refokussierungspuls erfassten Teilvolumen B, so hat sich ein Teil der ursprünglich angeregten Spins (schräg schraffierte Fläche C) vor der Refokussierung aus der Schicht (d.h. dem Zielvolumen) bewegt und trägt daher nicht zur Signalgebung bei, und das beobachtete Signal entstammt daher nur aus dem kreuzweise schraffierten Teilvolumen D.

Fig.2    Dito für eine Struktur S, welche sich während der Aufnahme der Gesamtheit der zur Bildrekonstruktion verwendeten Einzelschritte aus dem von der durch die schichtselektive Aufnahme erfassten Teilvolumen A (d.h. dem Zielvolumen) bewegt und am Ende der Bildaufnahme die Position S' außerhalb dieses Untersuchungsvolumens A erreicht. Da diese Struktur während eines Teils der Datenaufnahme keinen Signalbeitrag liefert, ist die zur Ortskodierung erforderliche Datenmenge unvollständig, was zu Bildartefakten führt.

Fig.3    Auswirkung der Objektbewegung auf die Phase $\Phi(t)$ von Spins, welche sich während der Aufnahme entlang einem Gradienten GS bewegen. B ist hierbei die magnetische Flussdichte, welche sich durch Anwendung eines Gradienten linear entlang der Richtung z des Gradienten ändert. RF zeigt den Anregungspuls einer MR-Sequenz, GS(z) zeigt das Schaltschema für den verwendeten Gradienten. Ein Signal für stationäre Spins entsteht dann, wenn das Integral über den Gradienten (schraffierte Fläche) gleich null ist. Für bewegte Spins ist diese Bedingung nicht erfüllt, sie erfahren eine der Bewegungsgeschwindigkeit proportionale Dephasierung $\Delta\Phi(v)$.

Fig.4    Prinzip des erfindungsgemäßen Verfahrens: die Position der jeweils untersuchten Schicht (d.h. das Zielvolumen) wird mit dem bewegten Zielobjekt im NMR-Tomographen mitgeführt, so dass die Positionen der Einzelschritte A1...Am zwar im Raum bezüglich des NMR-Tomographen verschieden sind, jedoch jeweils identische Volumina des bewegten Zielobjektes erfassen. Bei Spinecho-Verfahren, bei welchen schon für jeden Einzelschritt mehrere Pulse angewendet werden, wird die Schichtposition auch innerhalb jeden Echozuges mitgeführt. Die jeweiligen Schichtpositionen sind hier nur der Übersichtlichkeit wegen nebeneinander dargestellt, in Abhängigkeit von der Bewegungsgeschwindigkeit wird im Allgemeinen der Schichtfortsatz klein gegenüber der Schichtdicke sein.

Fig.5    Prinzip der kontinuierlichen Aufnahme eines mit der Geschwindigkeit $v_z$ bewegten Zielobjektes: In der Zeit t0..t1 werden die zur Aufnahme eines Datensatzes aus dem Zielvolumen 1 erforderlichen Einzelschritte A1..Am aufgenommen, wobei das Aufnahmevolumen mit dem Zielobjekt mitbewegt wird. Anschließend wird die Prozedur an einem zweiten, benachbarten Volumen 2 in der Zeit t2...t3 wiederholt. Bei mehrfacher Wiederholung lässt sich so sukzessive ein im Prinzip beliebig großes Zielobjekt kontinuierlich untersuchen.

Fig.6    Prinzip der kontinuierlichen Aufnahme eines Volumens bei Anwendung eines Mehrschichtaufnahmeverfahrens mit ns Einzelschichten: Die Aufnahmeschicht wird über k=m/ns Einzelschritte mit dem bewegten Objekt mitgeführt, anschließend wird die Aufnahmeschicht um genau eine Schichtposition ds im Objekt verschoben.

Fig.7    Prinzip der kontinuierlichen Aufnahme von Daten mit Sequenzen, welche unterschiedliche Bildkontraste bewirken: In dem durch A1..Am gekennzeichneten Teilvolumen wird eine Sequenz mit einem bestimmten Kontrastverhalten nach obigen Prinzipien durchgeführt. In B1...Bm wird verschachtelt hierzu eine zweite und andere Sequenz angewandt, welche einen unterschiedlichen Kontrast liefert. Durch die Bewegung des Objektes wird bei kontinuierlicher Aufnahme hierdurch das Objekt in zwei unterschiedlichen Kontrasten bei einmaligem Durchfahren erfasst.

Die Erfindung präsentiert ein Verfahren der MRT, bei welchem während der Datenaufnahme eine Bewegung des Objektes in Richtung des selektierten Volumens stattfindet und bei welchem die durch die Bewegung des Objektes auftretenden Signalverluste und Inkonsistenzen der Aufnahmedaten dadurch vermieden werden, dass das untersuchte Volumen mit dem bewegten Objekt mitgeführt wird und sämtliche zur Signalerzeugung notwendigen Rahmenbedingungen bezüglich der Magnetfeldgradienten und der verwendeten Hochfrequenzpulse entsprechend der Bewegung des Objektes angepasst werden,
insbesondere dass eine Mehrschichttechnik zur Untersuchung von ns Schichten verwendet wird, wobei bei einer NMR-Datenaufnahme mit m zur vollständigen Schichtrekonstruktion notwendigen Einzelschritten nach k=np*m/ns Einzelschritten die Position des Zielvolumens um eine Schichtdicke verändert wird, so dass nach Aufnahme von N*m Einzelschritten zu insgesamt N*ns(ns/npl) Schichten vollständige Daten zur Bildrekonstruktion vorliegen, wobei np≥ 1, N≥ 1.

## Patentansprüche

1.    Verfahren der Kernspinresonanz(=NMR)-Tomographie zur Untersuchung eines Zielobjekts, bei dem Hochfrequenz (=HF)-Impulse in ein Zielvolumen einstrählt und/oder HF-Impulse aus dem Zielvolumen detektiert werden, wobei das Zielvolumen durch die Frequenz der HF-Impulse und/oder durch Magnetfeldgradienten bestimmt ist, und wobei das Zielobjekt während der NMR-Datenaufnahme relativ zum NMR-Tomographen bewegt wird, wobei die Frequenz der HF-Impulse und/oder die Magnetfeldgradienten während der NMR-Datenaufnahme so verändert werden, dass das von den HF-Impulsen erfasste Zielvolumen während der NMR-Datenaufnahme mit der gleichen Geschwindigkeit und Bewegungsrichtung wie das Zielobjekt relativ zum NMR-Tomographen bewegt wird, wobei während der NMR-Datenaufnahme ein schichtförmiges Zielvolumen untersucht wird, wobei eine Mehrschichttechnik zur Untersuchung von ns Schichten angewendet wird, wobei mehrere NMR-Datenaufnahmen zyklisch wiederholt werden,
**dadurch gekennzeichnet,**
**dass** bei einer NMR-Datenaufnahme mit m zur vollständigen Schichtrekonstruktion notwendigen Einzelschritten nach k=np*m/ns Einzelschritten die Position des Zielvolumens um eine Schichtdicke verändert wird, so dass nach Aufnahme von N*m Einzelschritten zu insgesamt N*ns-(ns/np-1) Schichten vollständige Daten zur Bildrekonstruktion vorliegen, wobei np ≥ 1, N ≥ 1.

2.    Verfahren nach Anspruch 1, **dadurch gekennzeichnet, dass** die Bewegung des Zielobjekts parallel zur Oberflächennormalen des schichtförmigen Zielvolumens erfolgt.

3.    Verfahren nach einem der vorhergehenden Ansprüche, **dadurch gekennzeichnet, dass** während der NMR-Datenaufnahme die Magnetfeldgradienten konstant gehalten werden und nur die Frequenz der HF-Impulse verändert wird.

4. Verfahren nach Anspruch 3, **dadurch gekennzeichnet, dass** für die Larmorfrequenz ω der HF-Impulse gilt:

$$\omega(t) = \gamma * B_0 + \gamma * GS * v * t \ ,$$

mit γ: gyromagnetisches Verhältnis, $B_0$: statisches Magnetfeld, GS: Magnetfeldgradient, v: Geschwindigkeit des Zielobjekts, und t: Zeit.

5. Verfahren nach einem der vorhergehenden Ansprüche, **dadurch gekennzeichnet, dass** das Zielobjekt relativ zum NMR-Tomographen gleichförmig bewegt wird.

6. Verfahren nach einem der vorhergehenden Ansprüche, **dadurch gekennzeichnet, dass** die Magnetfeldgradienten in Bewegungsrichtung des Zielobjekts bewegungskompensiert bezüglich der Geschwindigkeit des Zielobjekts sind, insbesondere dass die Magnetfeldgradienten bipolar bewegungskompensiert sind.

7. Verfahren nach einem der vorhergehenden Ansprüche, **dadurch gekennzeichnet, dass** eine Multiecho-Sequenz nach dem Prinzip des RARE-Verfahrens angewendet wird, wobei zusätzlich die Pulsphase entsprechend den CPMG-Bedingungen der Bewegung des Zielobjektes angepasst wird.

8. Verfahren der NMR-Tomographie zur Untersuchung eines Zielobjekts, **dadurch gekennzeichnet, dass** mehrere NMR-Datenaufnahmen durch Verfahren nach einem der Ansprüche 1 bis 9 nacheinander durchgeführt werden, und wobei nach jeder NMR-Datenaufnahme die Position des Zielvolumens relativ zum NMR-Tomographen auf eine Ausgangsposition zurückgesetzt wird.

9. Verfahren nach einem der vorhergehenden Ansprüche, **dadurch gekennzeichnet, dass** während einer NMR-Datenaufnahme ein schichtförmiges Zielvolumen untersucht wird, und dass das Zielobjekt sich während einer NMR-Datenaufnahme genau um eine Schichtdicke weiterbewegt.

10. Verfahren nach einem der vorhergehenden Ansprüche, **dadurch gekennzeichnet, dass** während einer NMR-Datenaufnahme eine verschachtelte Anwendung von zwei oder mehreren Messsequenzen erfolgt, wobei die Messsequenzen im allgemeinen zu Signalen mit unterschiedlichem Kontrast führen, und wobei jede Messsequenz jeweils auf ein unterschiedliches Teilvolumen des Zielobjekts wirkt.

**Claims**

1. Nuclear magnetic resonance (NMR) tomography method for investigating a target object, wherein radio frequency (RF) pulses are irradiated into a target volume and/or RF pulses from the target volume are detected, wherein the target volume is determined by the frequency of the RF pulses and/or by magnetic field gradients, and wherein the target object is moved relative to the NMR tomograph during NMR data acquisition, wherein the frequency of the RF pulses and/or the magnetic field gradients is/are changed during NMR data acquisition such that the target volume covered by the RF pulses is moved at the same speed and in the same direction of motion as the target object relative to the NMR tomograph during NMR data acquisition, wherein during NMR data acquisition, a slice-shaped target volume is investigated, wherein a multi-slice technology is applied for investigating ns slices and several NMR data acquisitions are cyclically repeated, **characterized in that** during NMR data acquisition with m individual steps required for complete slice reconstruction, the position of the target volume is changed by one slice thickness after k=np*m/ns individual steps, such that the full data of a total of N*ns-(ns/np-1) slices is obtained for image reconstruction after acquisition of N*m individual steps, wherein np≥1, N≥1.

2. Method according to claim 1, **characterized in that** the target object moves parallel to the surface normal of the slice-shaped target volume.

3. Method according to any one of the preceding claims, **characterized in that** the magnetic field gradients are kept constant during NMR data acquisition and only the frequency of the RF pulses is changed.

4. Method according to claim 3, **characterized in that** the following applies for the Larmor frequency ω of the RF pulses:

$$\omega(t) = \gamma * B_0 + \gamma * GS * v * t \ ,$$

wherein $\gamma$ is the gyromagnetic ratio, $B_0$ is the static magnetic field, GS is the magnetic field gradient, v is the speed of the target object and t is the time.

5. Method according to any one of the preceding claims, **characterized in that** the target object is uniformly moved relative to the NMR tomograph.

6. Method according to any one of the preceding claims, **characterized in that** the motion of the magnetic field gradients is compensated in the direction of motion of the target object relative to the speed of the target object, in particular, that the motion of the magnetic field gradients is bipolarly compensated.

7. Method according to any one of the preceding claims, **characterized in that** a multi-echo sequence in accordance with the principle of the RARE method is applied, wherein the pulse phase is additionally adjusted to the motion of the target object in accordance with the CPMG conditions.

8. NMR tomography method for investigating a target object, **characterized in that** several NMR data acquisitions are consecutively carried out through methods in accordance with any one of the claims 1 through 9, and wherein after each NMR data acquisition, the position of the target volume relative to the NMR tomograph is reset to an initial position.

9. Method according to any one of the preceding claims, **characterized in that** during NMR data acquisition, a slice-shaped target volume is investigated, and the target object moves further by exactly one slice thickness during one NMR data acquisition.

10. Method according to any one of the preceding claims, **characterized in that** during NMR data acquisition, two or more measuring sequences are applied in a nested manner, wherein the measuring sequences generally produce signals with different contrast, and wherein each measuring sequence acts on a different partial volume of the target object.

## Revendications

1. Procédé de tomographie par résonance magnétique nucléaire (= RMN) pour l'examen d'un objet cible, dans lequel des impulsions à haute fréquence (= HF) sont émises dans un volume cible et/ou des impulsions HF provenant du volume cible sont détectées, le volume cible étant déterminé par la fréquence des impulsions HF et/ou par des gradients de champ magnétique, et l'objet cible étant déplacé par rapport au tomographe RMN pendant l'acquisition de données RMN, la fréquences des impulsions HF et/ou les gradients de champ magnétique étant modifiés pendant l'acquisition de données RMN de façon que le volume cible saisi par les impulsions HF soit déplacé par rapport au tomographe RMN à la même vitesse et dans la même direction de mouvement que l'objet cible pendant l'acquisition de données RMN, un volume cible sous forme de couche étant examiné pendant l'acquisition de données RMN, une technique multicouches étant utilisée pour l'examen de ns couches, plusieurs acquisitions de données RMN étant répétées cycliquement,
**caractérisé en ce
que** lors d'une acquisition de données RMN comprenant m étapes individuelles nécessaires pour la reconstruction de couche complète, la position du volume cible est modifiée d'une épaisseur de couche après k=np*m/ns étapes individuelles, de façon qu'après acquisition de N*m étapes individuelles, des données complètes pour au total N*ns-(ns/np-1) couches soient disponibles pour la reconstruction d'image, avec np ≥ 1, N ≥ 1.

2. Procédé selon la revendication 1, **caractérisé en ce que** le mouvement de l'objet cible s'effectue parallèlement à la normale à la surface du volume cible sous forme de couche.

3. Procédé selon l'une des revendications précédentes, **caractérisé en ce que** pendant l'acquisition de données RMN, les gradients de champ magnétique sont maintenus constants et seule la fréquence des impulsions HF est modifiée.

4. Procédé selon la revendication 3, **caractérisé en ce que** pour la fréquence de Larmor ω des impulsions HF s'applique :

$$\omega(t) = \gamma * B_0 + \gamma * GS * v * t,$$

avec γ : rapport gyromagnétique, $B_0$ : champ magnétique statique, GS : gradient de champ magnétique, v : vitesse de l'objet cible et t : temps.

5. Procédé selon l'une des revendications précédentes, **caractérisé en ce que** l'objet cible effectue un mouvement uniforme par rapport au tomographe RMN.

6. Procédé selon l'une des revendications précédentes, **caractérisé en ce que** les gradients de champ magnétique dans la direction de mouvement de l'objet cible sont compensés en mouvement par rapport à la vitesse de l'objet cible, en particulier que les gradients de champ magnétique sont compensés en mouvement de manière bipolaire.

7. Procédé selon l'une des revendications précédentes, **caractérisé en ce qu'**une séquence multi-écho selon le principe du procédé RARE est utilisée, la phase d'impulsion étant de plus adaptée en fonction des conditions de CPMG du mouvement de l'objet cible.

8. Procédé de tomographie RMN pour l'examen d'un objet cible, **caractérisé en ce que** plusieurs acquisitions de données RMN par le procédé selon l'une des revendications 1 à 9 sont effectuées successivement, la position du volume cible par rapport au tomographe RMN étant remise à une position de départ après chaque acquisition de données RMN.

9. Procédé selon l'une des revendications précédentes, **caractérisé en ce que** pendant une acquisition de données RMN, un volume cible sous forme de couche est examiné, et que l'objet cible continue à se déplacer d'exactement une épaisseur de couche pendant une acquisition de données RMN.

10. Procédé selon l'une des revendications précédentes, **caractérisé en ce que** pendant une acquisition de données RMN, deux ou plusieurs séquences de mesure sont utilisées de manière imbriquée, les séquences de mesure conduisant en général à des signaux de contraste différent, et chaque séquence de mesure agissant chaque fois sur un volume partiel différent de l'objet cible.

Fig.1

C    D

O

A=B

Fig.2

O

S'    S

A

Fig.3

# Fig.4

# Fig.5

$V_Z$

A1

t=

t0

Am

t1

A1

t2

Am

t3

# Fig.6

# Fig.7

Am    A1         Bm    B1

O

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0654675 A

- EP 0642031 A

**In der Beschreibung aufgeführte Nicht-Patentliteratur**

- **KRUGER et al.** *Magnet. Reson. Med.,* 2002, vol. 47, 224

- *Scheffler, Proc. 9th Meeting ISMRM,* 2001, 1774